Europäisches Patentamt

European Patent Office

Office européen des brevets

(19)

(11) **EP 1 199 572 A1**

(12) **EUROPÄISCHE PATENTANMELDUNG**

(43) Veröffentlichungstag:
**24.04.2002 Patentblatt 2002/17**

(51) Int Cl.7: **G01R 15/14**, G01R 33/02

(21) Anmeldenummer: **01124711.1**

(22) Anmeldetag: **16.10.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **20.10.2000 DE 10052171**

(71) Anmelder: **Vacuumschmelze GmbH & Co. KG**
**63450 Hanau (DE)**

(72) Erfinder:
• **Lenhard, Friedrich**
**63452 Hanau (DE)**
• **Schäfer, Stefan**
**55452 Rümmelsheim (DE)**

(74) Vertreter: **Patentanwälte**
**Westphal, Mussgnug & Partner**
**Mozartstrasse 8**
**80336 München (DE)**

(54) **Stromsensor nach dem Kompensationsprinzip mit schwimmender Bürde**

(57) Beschrieben ist ein Stromsensor oder Magnetfeldsensor nach dem Kompensationsprinzip, welcher an eine Versorgungsspannung $U_+$, $U_-$ mit Mittenpotential $U_{ref}$ anschließbar ist mit mind. einer Kompensationsspule 2,3 und einem Bürdenwiderstand $R_a$ mit folgender Besonderheit: Nach dem Einschwingen der Schaltung liegt an einer ersten Klemme 7 des Bürdenwiderstands $R_a$ liegt ein Referenzpotential $U_{ref}{}^a$ an. An der zweiten Klemme 8 liegt das Ausgangspotential $U_a = U_{ref}{}^a + (R_a * I_k)$ an. Der Bürdenwiderstand $R_a$ ist so mit einem oder mehreren weiteren Verstärkungselementen 6 verbunden, daß das am Ausgang 7,8 des Stromsensors oder Magnetfeldsensors anliegende Referenzpotential $U_{ref}{}^a$ durch die ein oder mehreren weitere Verstärkungselemente 6 auf ein von außen innerhalb des Versorgungsspannungsbereichs frei vorgebbares Referenzpotential $U_{ref}{}^e$ geregelt wird.

Fig. 2

**Beschreibung**

Die Erfindung betrifft einen Stromsensor gemäß Oberbegriff von Anspruch 1.

Es sind bereits eine Vielzahl von Stromsensoren nach dem Kompensationsprinzip unterschiedlicher Bauart im Stand der Technik vorgeschlagen worden. So wird in der EP-A- 0 742 440 und den mit dieser Schrift in Zusammenhang stehenden Gebrauchsmustern DE-U-295 20 066 und DE-U-295 07 675 ein Stromwandler nach dem Kompensationsprinzip beschrieben, bei dem in die Primärwicklung eines Ringkerns ein Meßstrom eingespeist wird. Mittels einer Magnetfeldsonde, die an einen Treiber (Gegentaktendstufe) angeschlossen ist, der den Sekundärstrom regelt, wird das Magnetfeld im Ringkern vollständig auf einen verschwindend kleinen Wert geregelt. Der Sekundärstrom ist dann ein Maß für den in der Primärspule fließenden Meßstrom. Als Magnetkerne für die Magnetfeldsonde kommen häufig streifenförmige Magnetmaterialien mit einer rechteckförmigen Magnetisierungsschleife, wie Beispielsweise VITROVAC 6025 (Fa. Vacuumschmelze GmbH) zum Einsatz.

Wird dieser Magnetkern wechselseitig in die Sättigung getrieben, kann das Magnetfeld besonders elegant über eine Verschiebung der B(H)-Magnetisierungs-Kurve auf der H-Achse bestimmt werden. Dieses Prinzip wird in der DE 198 44 726 ausführlich beschrieben.

Kompensationsstromwandler führen demnach in der Kompensationsspule einen Strom, der zum Primärstrom proportional ist. Die Stromstärke des Sekundärstroms wird üblicherweise mit einem "Shunt"- oder Bürdenwiderstand in ein Spannungssignal umgewandelt. Die sog. "Bürde" kann enweder "schwimmend" geschaltet sein oder auf einem fest vorgegebenen Potential liegen.

Die in den o.e. Druchschriften vorgeschlagenen Stromsensoren sehen eine schwimmende Bürde vor. Die Schaltungsanordnungen sind jedoch relativ aufwendig und somit kostenintensiv, da für die Auswertung des Spannungssignals an der Bürde eine Auswerteschaltung beispielsweise in Form eines Operationsverstärkers vorhanden sein muß.

Ein weiterer Stromsensor ist aus der DE 196 42 472 A bekannt. Bei dieser Bauart wird die Endstufe für den Kompensationsstrom über eine getaktete Endstufe angesteuert. Die Steuergröße für die Endstufe wird über ein frequenzmoduliertes Signal mit konstanter Pulslänge angesteuert.

Eine Ansteuerung der Endstufe mit einem Pulsweitenmodulationsverfahren ist aus der DE 197 05 767 C2 bekannt. Durch die Pulsweitenmodulation ergeben sich Vorteile hinsichtlich des Leistungsbedarfs der elektronischen Schaltung.

Die DE 198 44 726 beschreibt einen Stromsensor, bei dem eine Klemme des Bürdenwiderstandes entweder an einem festen Potential (Masse) anliegt oder aber der Spannungsabfall an der Kompensationsspule zur Bildung eines Ausgangssignals herangezogen wird. Das Ausgangssignal des Stromsensors wird in ein frequenzmoduliertes oder pulsweitenmoduliertes Signal umgewandelt. Der Stromsensor ist ferner mit einer Einrichtung zur Erkennung von Sensorfehlern (z.B. Latch-up) ausgestattet.

Wie weiter oben beschrieben sind Kompensationsstromsensoren mit schwimmender Bürde schaltungsaufwendig. In der deutschen Patentanmeldung P 199 36 860 wird daher die Bürde mit einer verlustfreien "sink-source"-Referenzspannungsquelle verschaltet, die an ihrem Ausgang die halbe Versorgungsspannung liefert. An einem Meßausgang der Schaltung liegt dann eine Spannung an, die proportional zum Meßstrom ist und eine Information über die Stromrichtung des Primärstroms enthält.

Der in der EP 0 691 544 A2 beschriebene Stromsensor arbeitet mit zwei Kompensationsspulen, die mit einer schwimmenden Bürde verschaltet sind. Durch die Aufteilung der Kompensationsspule in zwei Teilwicklungen läßt sich bei gleichem Innenwiderstand durch symmetrische Belastung der Versorgungsspannung bei gleichem Innenwiderstand der Teilwicklungen ein doppelt so hoher Kompensationsstrom erreichen. Nachteil dieser Schaltungsanordnung ist, daß eine niederohmige Referenzstromquelle benötigt wird, wodurch der Stromsensor bei einer Massenproduktion zu hohe Kosten verursachen würde. Insbesondere wenn nur eine unipolare Spannungsversorgung (z.B. 14 V in einem Kraftfahrzeug) zur Verfügung steht, wird eine aufwendige Referenz-"sink-source" benötigt.

Es besteht somit immer noch der Bedarf nach einem kostengünstigen Stromsensor mit möglichst hoher Ausnutzung des durch eine Stromversorgung vorgegebenen Versorgungsspannungshubs.

Diese Aufgabe wird erfindungsgemäß gelöst durch einen Stromsensor oder Magnetfeldsensor nach dem Kompensationsprinzip gemäß Anspruch 1.

Die Anordnung gemäß der Erfindung läßt sich gleichermaßen neben einer Messung von Strömen auch zur Messung von Magnetfeldern einsetzen. Im Falle der Strommessung muß der Kern des Sensors mit einer Primärspule bewickelt sein, wobei hier auch eine sehr geringe Windungszahl (z.B. durchgeführter Leiter) vorliegen kann. Werden Magnetfelder gemessen, so wird das Meßmagnetfeld durch die Kompensationsspule (n) geleitet. Dies kann bevorzugt unter Zuhilfenahme eines geeigneten Magnetkerns erfolgen. Anstelle des durchgeführten Leiters beim Stromsensor wird beim Magnetfeldsensor insbesondere ein entsprechender Magnetstab durchgeführt.

Nachfolgend wird zur Vereinfachung der Begriff "Stromsensor" anstelle von "Stromsensor oder Magnetfeldsensor" verwendet.

Erfindungsgemäß ist der Stromsensor an eine Versorgungsspannung mit Mittenpotential anschließbar.

In einer bevorzugten Ausführungsform der Erfindung sind zwei oder mehrere Kompensationsspulen vorhanden, die so mit dem Ausgang des ersten Verstärkungsbaustein verbunden sind, daß sich der durch die Sekundärspulen erzeugte Kompensationsmagnetfluß zu einem gemeinsamen Kompensationsmagnetfluß addiert und der volle Spannungsbereich der Versorgungsspannung ausgenutzt wird.

In einer weiteren bevorzugten Ausführungsform ist genau eine Kompensationsspule vorhanden ist, deren erster Anschluß mit dem Ausgang des ersten Verstärkungsbaustein verbunden ist und deren zweiter Anschluß mit dem Bürdenwiderstand $R_a$ verbunden ist.

Vorzugsweise ist der Innenwiderstand der Kompensationsspule so dimensioniert, daß dieser nahezu oder ganz dem Widerstand des Bürdenwiderstands $R_a$ entspricht.

Das weitere Verstärkungselement ist vorzugsweise ein Differenzverstärker, dessen erster Eingang mit dem das Referenzpotential führenden Ausgang $U_{ref}^a$ am Bürdenwiderstand und dessen zweiter Eingang mit dem am Stromsensor anliegenden Referenzpotential $U_{ref}^e$ verbunden ist.

Die zwei oder mehrere Kompensationsspulen bestehen bevorzugt aus jeweils zwei oder mehreren gemeinsam gewickelten oder geführten Stromleitern.

Dies ist inbesondere deshalb von Vorteil, da gemäß der Erfindung die Referenzspannung am Meßwiderstand elektronisch hochohmig geregelt wird. Zur Messung von Strömen mit hohen Frequenzanteilen ist es daher zweckmäßig, daß die Kopplung von Primärwicklung zu einer Teilwicklung genauso groß ist, wie zur zweiten oder den ggf. vorhandenen weiteren Teilwicklungen der Kompensationsspule. Ferner ist es zweckmäßig, daß die Innenwiderstände der Stromzweige zu den Teilwicklungen im Kompensationsspulenbereich im wesentlichen gleich groß sind.

Besonders bevorzugt sind im Falle eines Stromsensors mit eine Primärwicklung $I_1$, durch die der Meßstrom fließt, zur Erzeugung einer gleichmäßigen Magnetflußkreis-Kopplung vorzugsweise die Primärwicklung ebenfalls wie die Sekundärwicklungen gemeinsam über den gleichen Kernabschnitt, insbesondere im gleichen Wickelraum, des Stromsensormagnetkerns geführt (Tandemwicklung).

Ganz besonders bevorzugt ist auch die Primärwicklung über den gleichen Kernabschnitt geführt. Der Stromsensor läßt sich jedoch auch betreiben, wenn die Primärwicklung über einen anderen Bereich des Kerns geführt ist.

Vorteilhafterweise läßt sich der erfindungsgemäße Stromsensor, was bevorzugt ist, in einem ASIC integrieren. Besonders bevorzugte Verstärkungselemente gemäß der Erfindung sind dann PWM-Treiber. Werden allerdings nur Kompensationsströme von weniger als etwa 200 mA benötigt, so läßt sich eine Integration in einen ASIC auch mittels linearer Treiber realisieren.

Der Stromsensor gemäß der Erfindung weist eine erheblich geringere Verlustleistung $P_{verl}$ auf, als bekannte Stromsoren. Zum Beispiel im Vergleich zum bereits diskutierten Stromsensor mit schwimmender Bürde, wie er in der deutschen Patentanmeldung P 199 36 860 beschrieben ist, weist der erfindungsgemäße Stromsensor eine Verlustleistung auf, die um den Faktor 4 geringer ist:

Die Verlustleistung berechnet sich beim bekannten Stromsensor durch die Formel

$$P_{verl} = U_{ref}^e {}_* I.$$

Der Stromsensor gemäß der Erfindung weist eine Verlustleistung von

$$P_{verl} = (U_{ref}^e - I * R_a) * I \text{ auf.}$$

Nachfolgend wird die Erfindung an Hand von Beispielen, die in den Figuren dargestellt sind, näher erleutert. Weitere bevorzugte Ausführungsformen ergeben sich aus der Figurenbeschreibung.

Es zeigen

Fig. 1a und 1b      Schaltungsanordnungen für erfindungsgemäße Stromsensoren mit einer Sekundärspule,

Fig. 2      eine Schaltungsanordnung eines erfindungsgemäßen Stromsensors mit zwei Sekundärspulen und

Fig. 3      eine schematische Darstellung eines bewickelten Magnetkerns mit Tandemwicklung.

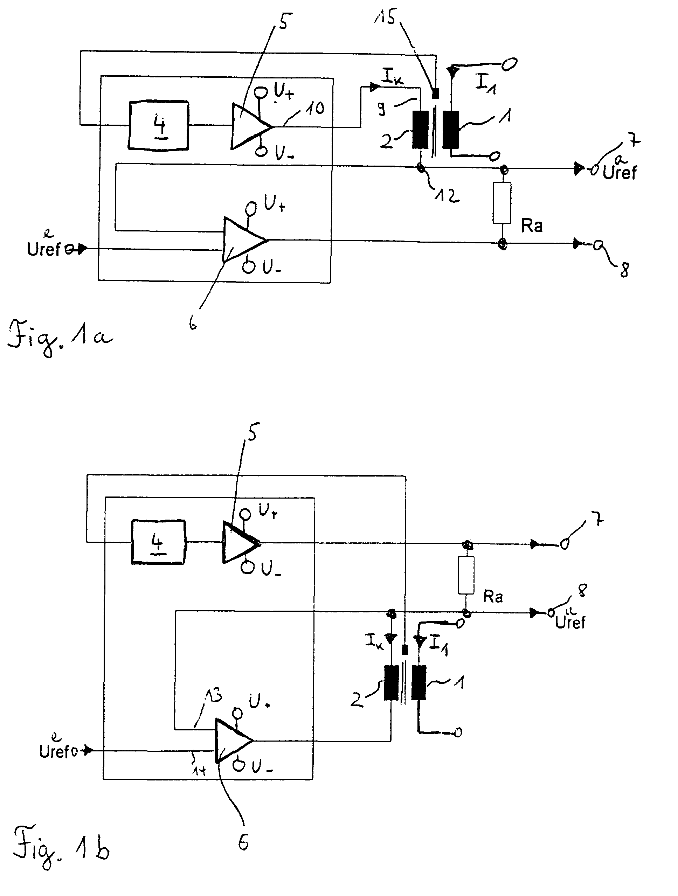

Der Stromsensor in Fig. 1a wird an eine Spannungsquelle mit den Klemmen $U_{ref}^e$, $U_+$ und $U_-$ angeschlossen. Beispiele für entsprechend zuzuordnende Spannungen sind 2,5 V, 5 V und 0 V oder 0 V, 15 V und - 15 V.

Der Magnetfeldsensor 15 nimmt das Magnetfeld im Kernbereich des Stromsensors auf, welches durch den Primärstrom $I_1$ (Meßstrom) erzeugt wird. Das Signal wird im Auswerteelement 4 ausgewertet und in ein Spannungssignal umgewandelt, welches dem Treiber 5 zugeführt ist. Der Ausgang von Treiber 5 ist über Leitung 10 an eine erste Klemme 9 der Kompensationsspule 2 verbunden. Die zweite Klemme der Kompensationsspule ist mit einem ersten Eingang eines weiteren Treibers 6 und einer ersten Klemme von Widerstand $R_a$ (Bürde) verbunden. Diese erste Klemme von $R_a$ ist mit einem Ausgang 7 ($U_{ref}^a$) des Stromsensors verschaltet. Der zweite Ausgang des Stromsensors 8 ist mit der zweiten Klemme von $R_a$ und dem Ausgang des weiteren Treibers 6 verbunden. Schließlich besteht eine Verbindung zwischen Klemme $U_{ref}^e$ und dem zweiten Eingang des weiteren Treibers 6.

Im Betrieb des Stromsensors bewirkt der Anstieg des Stroms von Treiber 6 eine Verschiebung des Potentials $U_{ref}^a$ solange, bis sich das Potential $U_{ref}^a$ und $U_{ref}^e$ einander angeglichen haben.

In Fig. 1b ist ein Stromsensor dargestellt, der im Vergleich zu Fig. 1a einen gespiegelten Aufbau hat. Die Beschreibung des Aufbaus und der Arbeitsweise entspricht im wesentlichen der von Fig. 1a.

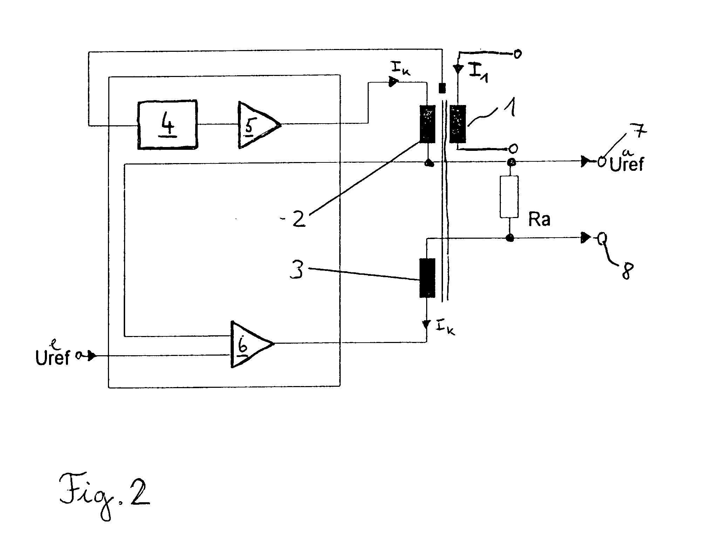

Die Stromsensorschaltung in Fig. 2 ist durch zwei Kompensationsspulen 2 und 3 gekennzeichnet, die beide symmetrisch mit dem Bürdenwiderstand $R_a$ verbunden sind. Die Schaltung unterscheidet sich von der Schaltung in Fig 1a dadurch, daß zwischen dem Ausgang des weiteren Treibers 6 und der zweiten Klemme von $R_a$ eine zusätzliche Kompensationsspule 3 geschaltet ist.

Im Beispiel entspricht die Kopplung an den Primärkreis der zweiten Spule durch eine Tandemwicklung der der ersten Spule. Die Innenwiderstände der Stomzweige, die die Kompensationsspulen treiben, sind dann praktisch gleich groß.

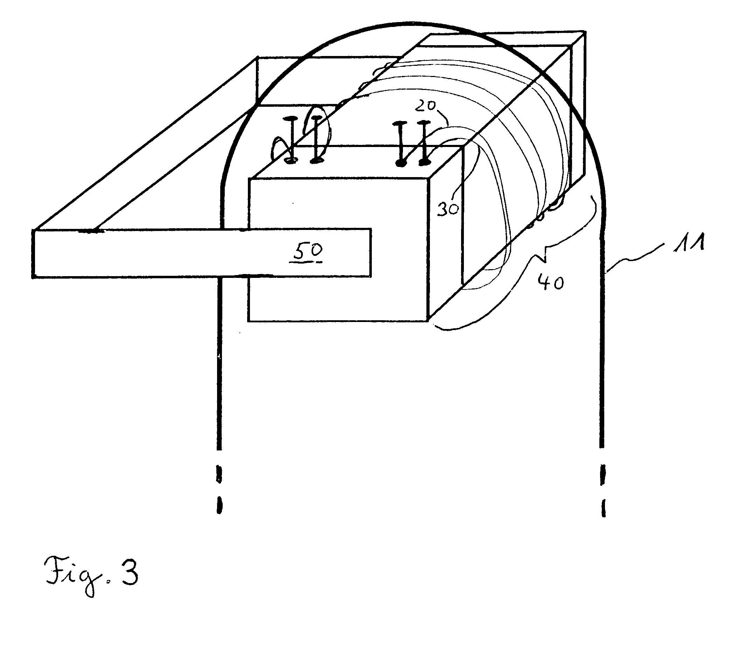

In Fig. 3 ist der Spulenaufbau des Stromsensors schematisch dargestellt. Der Magnetkern 50, der auch unterbrochen sein kann, bildet einen geschlossenen Magnetflußkreis. Um den Kern 50 sind die Windungen von Primär-"Spule" 11 und Kompensationsspulen 20, 30 aufgebracht. Die Primär-"Spule" kann aus mehreren Windungen bestehen oder nur aus einer am Kern vorbeigeführten Drahtschleife 11. Im Kernabschnitt 40 ist die Tandemwicklung durch gleichzeitiges Wickeln der beiden Drähte 20, 30 augebracht.

**Patentansprüche**

1. Stromsensor oder Magnetfeldsensor nach dem Kompensationsprinzip, welcher an eine Versorgungsspannung ($U_+$, $U_-$) mit Mittenpotential ($U_{ref}$) anschließbar ist, mit oder ohne Primärspule (1), mind. einer Kompensationsspule (2,3) und einem Bürdenwiderstand $R_a$, wobei der Strom $I_k$ in der Kompensationsspule in Abhängigkeit vom Magnetfeld im Sensormagnetflußkreis mittels mindestens einem ersten Verstärkungsbaustein (5,6) so geregelt wird, daß das Magnetfeld im Sensormagnetflußkreis verschwindet und am Bürdenwiderstand eine zum Primärstrom $I_1$ proportionale Spannung $U_a$ anliegt,

**dadurch gekennzeichnet,**

**daß** nach dem Einschwingen der Schaltung an einer ersten Klemme (7) des Bürdenwiderstands $R_a$ schwimmend ein Referenzpotential $U_{ref}^a$ anliegt, an der zweiten Klemme (8) von $R_a$ das Ausgangspotential $U_a = U_{ref}^a + (R_a * I_k)$ anliegt, der Bürdenwiderstand $R_a$ so mit einem oder mehreren weiteren Verstärkungselementen (6) verbunden ist, daß das am Ausgang (7,8) des Stromsensors oder Magnetfeldsensors anliegende Referenzpotential $U_{ref}^a$ durch die ein oder mehreren weitere Verstärkungselemente (6) auf ein von außen innerhalb des Versorgungsspannungsbereichs frei vorgebbares Referenzpotential $U_{ref}^e$ geregelt wird und die Spannung $U_{ref}^a$-$U_a$ den zum Primärstrom bzw. zum messenden Magnetfeld proportionalen Ausgang des Strom- bzw. Magnetfeldsensors bildet.

2. Stromsensor oder Magnetfeldsensor nach Anspruch 1,

**dadurch gekennzeichnet,**

**daß** zwei oder mehrere Kompensationsspulen (2,3) vorhanden sind, die so mit dem Ausgang des ersten Verstärkungsbaustein verbunden sind, daß sich der durch die Sekundärspulen erzeugte Kompensationsmagnetfluß zu einem gemeinsamen Kompensationsmagnetfluß addiert und der volle Spannungsbereich der Versorgungsspannung ausgenutzt wird.

3. Stromsensor oder Magnetfeldsensor nach Anspruch 1,

**dadurch gekennzeichnet,**

**daß** genau eine Kompensationsspule (2) vorhanden ist, deren erster Anschluß (9) mit dem Ausgang des ersten Verstärkungsbaustein (10) verbunden ist und deren zweiter Anschluß (12) mit dem Bürdenwiderstand $R_a$ verbunden ist.

4. Stromsensor oder Magnetfeldsensor nach mindestens einem der Ansprüche 1 bis 3,

**dadurch gekennzeichnet,**

**daß** das weitere Verstärkungselement (6) ein Differenzverstärker ist, dessen erster Eingang (13) mit dem das Referenzpotential führenden Ausgang $U_{ref}^a$ am Bürdenwiderstand und dessen zweiter Eingang (14) mit dem am Stromsensor anliegenden Referenzpotential $U_{ref}^e$ verbunden ist.

6. Stromsensor oder Magnetfeldsensor nach mindestens einem der Ansprüche 1,2 und 4 und 5,

**dadurch gekennzeichnet,**

**daß** die zwei oder mehrere Kompensationsspulen (2,3) aus jeweils zwei oder mehreren gemeinsam gewickelten oder geführten Stromleitern (20,30) bestehen, so daß die magnetische Kopplung der Kompensationsspulen zum gemeinsamen Sensormagnetflußkreis im wesentlichen gleich ist.

7. Magnetfeldsensor nach einem der Ansprüche 1 bis 6,

**dadurch gekennzeichnet,**

**daß** das Magnetfeld im Sensormagnetflußkreis durch einen Magnetstab erzeugt wird, auf den ein äußeres Magnetfeld einwirkt.

Fig. 1a

Fig. 1b

Fig. 2

Fig. 3

**Europäisches Patentamt**

# EUROPÄISCHER TEILRECHERCHENBERICHT

der nach Regel 45 des Europäischen Patentübereinkommens für das weitere Verfahren als
europäischer Recherchenbericht gilt

**Nummer der Anmeldung**

EP 01 12 4711

## EINSCHLÄGIGE DOKUMENTE

| Kategorie | Kennzeichnung des Dokuments mit Angabe, soweit erforderlich der maßgeblichen Teile | Betrifft Anspruch | KLASSIFIKATION DER ANMELDUNG (Int.Cl.7) |
|---|---|---|---|
| X | US 5 896 028 A (ARAI YOICHI) 20. April 1999 (1999-04-20) * Zusammenfassung; Abbildungen 1,3 * * Spalte 1, Zeile 30 - Spalte 2, Zeile 56 * * Spalte 5, Zeile 7 - Zeile 12 * --- | 1-4,6,7 | G01R15/14 G01R33/02 |
| X | US 5 654 630 A (SHIMOYAMA KENICHI ET AL) 5. August 1997 (1997-08-05) * Zusammenfassung; Abbildungen 1,2 * --- | 1-4,6,7 | |
| A,P, D | DE 199 36 860 A (VACUUMSCHMELZE GMBH) 15. Februar 2001 (2001-02-15) * Zusammenfassung; Abbildung 1 * ----- | 1 | |

**RECHERCHIERTE SACHGEBIETE (Int.Cl.7)**

G01R
H02M

## UNVOLLSTÄNDIGE RECHERCHE

Die Recherchenabteilung ist der Auffassung, daß ein oder mehrere Ansprüche, den Vorschriften des EPÜ in einem solchen Umfang nicht entspricht bzw. entsprechen, daß sinnvolle Ermittlungen über den Stand der Technik für diese Ansprüche nicht, bzw. nur teilweise, möglich sind.

Vollständig recherchierte Patentansprüche:

1-4

Unvollständig recherchierte Patentansprüche:

6,7

Nicht recherchierte Patentansprüche:

Grund für die Beschränkung der Recherche:

Die Angabe über die Abhängigkeit der Ansprüche 6 und 7 ist unverständlich. Anspruch 5 fehlt völlig.

| Recherchenort | Abschlußdatum der Recherche | Prüfer |
|---|---|---|
| BERLIN | 11. Dezember 2001 | Fritz, S |

EPO FORM 1503 03.82 (P04C09)

## ANHANG ZUM EUROPÄISCHEN RECHERCHENBERICHT
## ÜBER DIE EUROPÄISCHE PATENTANMELDUNG NR.

EP 01 12 4711

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-12-2001

| Im Recherchenbericht angeführtes Patentdokument | | Datum der Veröffentlichung | Mitglied(er) der Patentfamilie | | Datum der Veröffentlichung |
|---|---|---|---|---|---|
| US 5896028 | A | 20-04-1999 | JP | 9257837 A | 03-10-1997 |
| US 5654630 | A | 05-08-1997 | JP<br>JP | 3153729 B2<br>8304468 A | 09-04-2001<br>22-11-1996 |
| DE 19936860 | A | 15-02-2001 | DE | 19936860 A1 | 15-02-2001 |

EPO FORM P0461

Für nähere Einzelheiten zu diesem Anhang : siehe Amtsblatt des Europäischen Patentamts, Nr.12/82